(19) Europäisches Patentamt

European Patent Office

Office européen des brevets

(11) Veröffentlichungsnummer: **0 303 808**
**A2**

## (12) EUROPÄISCHE PATENTANMELDUNG

(21) Anmeldenummer: 88110589.4

(22) Anmeldetag: 02.07.88

(51) Int. Cl.⁴: **H01L 31/02 , H01L 25/04**

(30) Priorität: **17.08.87 DE 3727389**

(43) Veröffentlichungstag der Anmeldung:
**22.02.89 Patentblatt 89/08**

(84) Benannte Vertragsstaaten:
**AT CH DE ES FR GB IT LI NL SE**

(71) Anmelder: **DR. JOHANNES HEIDENHAIN GMBH**
**Dr.-Johannes-Heidenhain-Strasse 5 Postfach 1260**
**D-8225 Traunreut(DE)**

(72) Erfinder: **Kranitzky, Walter, Dr.**
**Innstrasse 15**
**D-8220 Traunstein(DE)**

(54) **Elektrische Verbindung.**

(57) Bei einer derartigen elektrischen Verbindung sind mehrere Fotoelemente (1-6) auf einer Leiterplatte (7) montiert. Die Kontaktflächen auf der Oberseite der oberflächenmontierten Fotoelemente (1-6) sind jeweils über einen Kupferdraht (10-15) mit Kontaktstellen auf der Leiterplatte (7) verbunden. Diese Kupferdrähte (10-15) sind in einer gemeinsamen flexiblen Folie (17) eingebettet, die einen rahmenförmigen Träger mit einer Öffnung (18) für die Fotoelemente (1-6) bildet. Die Anordnung der Fotoelemente auf der Leiterplatte (7) ist Bestandteil einer Abtasteinrichtung einer lichtelektrischen, inkrementalen Positionsmeßvorrichtung.

FIG. 1

EP 0 303 808 A2

## Elektrische Verbindung

Die Erfindung betrifft eine elektrische Verbindung gemäß dem Oberbegriff des Anspruchs 1.

In zunehmendem Maße kommen bei der Bestückung von Leiterplatten oberflächenmontierte Bauelemente (SMD's) zur Anwendung. Ein Hauptvorteil der Oberflächenmontage ist der geringe Platzbedarf der Bauelemente.

Bei Drehgebern und Längenmeßvorrichtungen wird häufig das lichtelektrische Abtastprinzip von inkrementalen oder absoluten Maßverkörperungen praktiziert. Bei derartigen Drehgebern und Längenmeßeinrichtungen wird eine kompakte Bauform gefordert, weshalb die Bauelemente der Abtasteinheit auch auf engstem Raum untergebracht werden müssen. Die Bauelemente zur Abtastung der Maßverkörperung befinden sich auf einer kleinen Leiterplatte, wobei sich hier bereits die Oberflächenmontage von optoelektronischen Halbleiterbauelementen in Form von Silizium- Fotoelementen durchgesetzt hat. Die metallisierte Rückseite mehrerer Fotoelemente wird mit der dafür vorgesehenen Leiterfläche der Leiterplatte verbunden. Für die Verbindung der Oberseitenkontakte der Fotoelemente sind Gold- und Aluminiumdrähte, die im Mikroschweißverfahren angeschlossen werden, aber auch in Löttechnik verarbeitete Kupferdrähte gebräuchlich. Aus Stabilitätsgründen ist die Oberflächenkontaktierung der Fotoelemente in reiner Löttechnik vorzuziehen. Bei diesem Verfahren werden die oberen Kontaktflächen, der in Gruppen angeordneten Fotoelemente einzeln mittels eines Lötkolbens über Kupferdrähte mit der Leiterplatte verbunden. Bei mehreren Fotoelementen ist dieser Vorgang sehr zeitaufwendig und es können leicht mangelhafte Kontaktstellen entstehen.

Aus der Zeitschrift "Siemens Components", 1986, Heft 6, Seiten 225-229 ist eine Bauform für integrierte Schaltungen, die ausschließlich auf die Oberflächenmontage hin konzipiert ist, bekannt. Diese Mikropack-Bauform, auch unter TAB bekannt, besteht aus einem hermetisch versiegelten Chip und daran gelöteten Kupferbändchen als Anschlußleitungen. Alle Anschlußleitungen für die Lötung des Chips und die später benötigten Außenanschlüsse der Mikropack-Bauform sind in einer Polyimidfolie integriert, die ein Fenster für den Chip aufweist. Der Chip wird im verlöteten Zustand an den Kunden geliefert, d.h. daß die Kontaktflächen des Chips mit den einen Enden der Anschlußleitungen innerhalb des Fensters verlötet sind, und der Chip mit den Anschlußleitungen und der Polyimidfolie als eine Einheit dem Kunden geliefert wird, der die Außenanschlüsse dieser Einheit mit Leiterbahnen einer Leiterplatte zu verbinden hat. Eine Anordnung optoelektronischer Halbleiterbauelemente in einer derartigen Bauform ist nicht bekannt.

Der Erfindung liegt die Aufgabe zugrunde, eine einfache, zuverlässige und wirtschaftliche elektrische Verbindung einer Anordnung von oberflächenmontierten optoelektronischen Halbleiterbauelementen mit einem Substrat zu schaffen.

Diese Aufgabe wird erfindungsgemäß durch die Merkmale des Anspruchs 1 gelöst.

Die mit der Erfindung erzielten Vorteile bestehen insbesondere darin, daß die oberen Kontaktflächen mehrerer optoelektronischer Halbleiterbauelemente in einem Arbeitsgang mit Leiterbahnen einer Leiterplatte verbunden werden können, daß eine unterschiedliche Wärmebehandlung der einzelnen optoelektronischen Halbleiterbauelemente vermieden wird, und daß weiterhin eine mechanische Beschädigung durch unsachgemäße Lötung ausgeschlossen ist.

Ein Ausführungsbeispiel der Erfindung wird anhand der Zeichnungen näher erläutert.

Es zeigt

Figur 1 eine Draufsicht auf eine Anordnung von Fotoelementen einer Leiterplatte und

Figur 2 einen Querschnitt entlang der Linie II-II nach Figur 1.

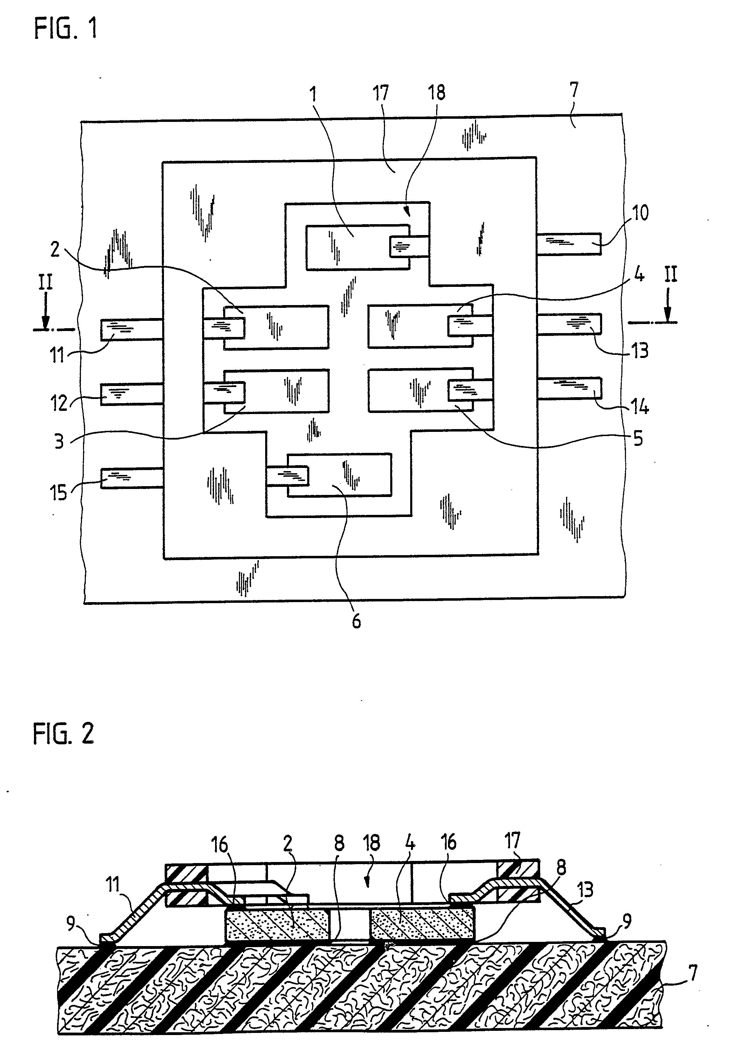

In Figur 1 ist in einer Draufsicht eine Anordnung von optoelektronischen Halbleiterbauelementen in Form von Fotoelementen 1-6 gezeigt. Die Fotoelemente 1-6 sind jeweils mit der metallisierten Rückseite mit der dafür vorgesehenen, nicht gezeigten Leiterfläche einer Leiterplatte 7 verbunden. Die Leiterplatte 7 ist Bestandteil einer Abtasteinheit eines inkrementalen, lichtelektrischen Meßgerätes. Vier Fotoelemente 2-5 sind einer inkrementalen, lichteletrisch abtastbaren Teilung so zugeordnet, daß an den Ausgängen der Fotoelemente 2-5 vier, um 90° gegeneinander phasenverschobene Abtastsignale abnehmbar sind. Das Fotoelement 1 ist einer sog. Gleichlichtspur und das Fotoelement 6 einer Referenzmarkenspur zugeordnet. Vor dem Bestücken mit den Fotoelementen 1-6 ist Lotpaste 8 als leitende Zwischenschicht an den Stellen der Leiterplatte 7 aufgebracht worden, an denen sie zu positionieren sind. Im gleichen Verfahrensschritt kann auch die Lotpaste 9 für die Kontaktierung der Kupferdrähte 10-15 auf die Leiterplatte 7 aufgebracht werden. Nach dem Positionieren der Fotoelemente 1-6 von Hand oder mit Bestückungsautomaten wird Lotpaste 16 auf die Kontaktflächen auf der Oberseite der Fotoelemente 1-6 aufgetragen.

Die elektrischen Verbindungen zwischen den Kontaktflächen auf der Oberseite der Fotoelemente 1-6 und den Kontaktstellen mit der Lotpaste 9, auf der Leiterplatte 7, erfolgen mittels der Kupferdrähte 10-15. Eine flexible Folie 17 (z.B. Polyimid) bildet einen rahmenförmigen Träger, in dem alle benötigten Kupferdrähte 10-15 integriert sind. Die Länge der Kupferdrähte 10-15 ist so gewählt, daß jeweils ein Ende in die Öffnung 18 hineinragt und das andere Ende über die Folie 17 hinausragt. Wie aus Figur 2 zu sehen ist, sind die Kupferdrähte 10-15 so vorgebogen, daß die Enden, die in die Öffnung 18 hineinragen, auf der Oberseite der Fotoelemente 1-6 aufliegen. Die Enden der Kupferdrähte 10-15, die über die Folie 17 hinausragen, sind derart vorgebogen, daß sie mit der Lotpaste 9 auf der Leiterplatte 7 in Kontakt stehen. Alle elektrischen Verbindungen zwischen den Kontaktflächen auf der Oberseite der Fotoelemente 1-6 und den Kontaktstellen auf der Leiterplatte 7 werden durch Aufsetzen und Positionieren der Folie 17 sowie durch nachfolgendes Reflow-Löten im Infrarot-Ofen erzeugt. Die mechanische Festigkeit der so erzeugten Verbindungen ist sehr hoch und durch das Reflow-Löten werden die Fotoelemente 1-6 gleich hohen Temperaturen ausgesetzt und es erfolgt eine selbsttätige Feinpositionierung der Fotoelemente 1-6 durch Kohäsionseffekte.

Für manche Anwendungsfälle kann es vorteilhaft sein, die Anordnung der Fotoelemente 1-6 mit der Folie 17 und den Kupferdrähten 10-15 vollständig vergossen zu verwenden. Hierzu kann der zu vergießende Bereich mit einem Rahmen begrenzt werden. Wenn es die Platzverhältnisse zulassen, kann der Rahmen auf der Leiterplatte verbleiben, andernfalls kann die transparente Vergußmasse in eine, auf die Leiterplatte aufgesetzte Form aus Silikonkautschuk gegossen werden, die nach dem Aushärten des Silikonkautschuks entfernt und wieder verwendet werden kann.

Die Anschlußleitungen müssen nicht in Form von Kupferdrähten 10-15 ausgeführt sein, es sind auch andere Metalle denkbar. Weiterhin sind die Kupferdrähte 10-15 in der gezeigten Ausführung in die Folie 17 eingegossen, es können aber auch Anschlußleitungen in Folienform verwendet werden, die zwar fest mit der flexiblen Folie 17 verbunden, aber nicht eingegossen sind.

Die Erfindung ist nicht auf die gezeigte Anordnung von Fotoelementen 1-6 beschränkt, sie kann auch für weitere Anordnungen optoelektronischer Halbleiterbauelemente mit Erfolg angewandt werden.

## Ansprüche

1. Elektrische Verbindung einer Anordnung von oberflächenmontierten optoelektronischen Halbleiterbauelementen mit einem Substrat, wobei eine Oberfläche jedes optoelektronischen Halbleiterbauelementes der Anordnung über zumindest eine elektrische Anschlußleitung mit jeweils einer Kontaktstelle des Substrats verbunden ist, dadurch gekennzeichnet, daß diese Anschlußleitungen (10-15) in einem gemeinsamen Träger (17) integriert sind.

2. Elektrische Verbindung nach Anspruch 1, dadurch gekennzeichnet, daß der gemeinsame Träger eine flexible Folie (17) ist.

3. Elektrische Verbindung nach Anspruch 1 oder 2, dadurch gekennzeichnet, daß jedes der optoelektronischen Halbleiterbauelemente (1-6) mit seiner Unterseite über eine elektrisch leitfähige Zwischenschicht (8) auf dem Substrat (7) befestigt ist und eine Kontaktfläche auf der Oberseite jedes optoelektronischen Halbleiterbauelementes (1-6) über je eine Anschlußleitung (10-15) des gemeinsamen Trägers (17) mit den Kontaktstellen des Substrats (7) verbunden ist.

4. Elektrische Verbindung nach Anspruch 2, dadurch gekennzeichnet, daß die optoelektronischen Halbleiterbauelemente Fotoelemente (1-6) sind, von denen jedes mit seiner Unterseite über eine elek trisch leitfähige Zwischenschicht (8) auf einer gemeinsamen Leiterplatte (7) befestigt ist und von denen jeweils die Kontaktfläche auf der Oberseite über je eine Anschlußleitung (10-15) der flexiblen Folie (17) mit Kontaktstellen der Leiterplatte (7) verbunden ist, wobei die Folie (17) einen Rahmen mit zumindest einer Öffnung (18) für die Fotoelemente (1-6) bildet, und die einen Enden der Anschlußleitungen (10-15), zur elektrischen Verbindung mit der Oberseite der Fotoelemente (1-6), in die Öffnung (15) hineinragen und die anderen Enden der Anschlußleitungen (10-15), zur elektrischen Verbindung mit der Leiterplatte (7), über die Folie (17) hinausragen.

5. Elektrische Verbindung nach Anspruch 4, dadurch gekennzeichnet, daß die Fotoelemente (1-6), die flexible Folie (17) sowie die Anschlußleitungen (10-15) mit transparenter Vergußmasse gemeinsam auf der Leiterplatte (7) vergossen sind.

6. Elektrische Verbindung nach einem der vorhergehenden Ansprüche, dadurch gekennzeichnet, daß die Leiterplatte (7) mit der Anordnung der optoelektronischen Halbleiterbauelemente (1-6) Bestandteil einer Abtasteinrichtung einer lichtelektrischen, inkrementalen Positionsmeßvorrichtung ist.

7. Elektrische Verbindung nach einem der vorhergehenden Ansprüche, dadurch gekennzeichnet, daß die Leiterplatte (7) mit der Anordnung der optoelektronischen Halbleiterbauelemente (1-6) Bestandteil einer Abtasteinrichtung einer lichtelektrischen, absoluten Positionsmeßvorrichtung ist.

FIG. 1

FIG. 2